# EUROPEAN PATENT APPLICATION

(11) **EP 2 103 949 A2**
(43) Date of publication of application: **23.09.2009**
(21) Application number: 09461503.6
(22) Date of filing: 17.03.2009
(51) Int. Cl.: G01R 22/10

(54) **System for measurement and control of electrical energy consumption**

(30) Priority: 17.03.2008 PL 38471608
(71) Applicant: Politechnika Lubelska, Lublin (PL)
(72) Inventor: Bober, Dariusz, 20-488 Lublin (PL)
(74) Representative: Belz, Anna

(57) **Abstract**

The system for measurement and control of electrical energy consumption has *n* separated tracks (TR₁, TR₂, TR₃, ..., TRₙ), preferably three tracks, which are connected to the supply line (L1) through the controllable current relays (P₁, P₂, P₃, ... Pₙ), controlled by a microprocessor-based data collection and processing system (3), with the feedback channel (4) being a channel for the transmission of measurement data and control messages in IP packets to/from external operator and connected to the electronic systems (LE₁, LE₂, LE₃, ... LEₙ) for measuring the consumption of electrical energy at each track (TR₁, TR₂, TR₃, ..., TRₙ) individually, the microprocessor-based data collection and processing system (3) has an LCD screen (6) to display actual information of the system for measurement and control of electrical energy consumption status and has a set of buttons (7) for interacting with user by displaying context menu on the LCD screen (6), and the supply of power to the tracks (TR₁, TR₂, TR₃, ..., TRₙ) is controlled either manually using the buttons (PR₁, PR₂, PR₃, ... ,PRₙ) or automatically via the microprocessor system (3) of data processing and collecting by switching on/off the controllable current relays (P₁, P₂, P₃, ... Pₙ).

## Description

The object of the invention is a system for measurement and control of electrical energy consumption.

Some systems for measurement of electrical energy consumption are known and they are in use till now, eg systems for measurement one-phase AC presented in E. Sroczan's book titled "Modern technical equipment of households. Electrical Equipment.", State agricultural and forest publisher, Poznan 2004 p. 316-319. From the book there are known some components of system for control of electrical energy consumption, too. Also, from M. Stabrowski's book, titled "Digital Measuring Instruments", PWN, Warsaw 2002, p. 152-154, there is known a system for electrical energy consumption control in three-phase network, using microprocessor-based electronic systems to measure electric energy consumption. From the Polish patent application No P.353466 there is known the device for measuring the consumption of electrical energy, which allows a supplier and a recipient for the current electrical energy consumption measure reading and the measurement data collecting. This process of data collection is independent of access to common IT systems and the location of measure point. And, from D. Bober's publication, titled "The electrical energy customer powering by power modes", Energy Market, No 1(74) Feb. 2008, p. 27-32, there is known the method of electrical energy customer powering by power modes.

The essence of the system for measurement and control of electrical energy consumption, which is composed of controllable current relays, electronic systems for measuring the consumption of electric energy, a microprocessor-based data collection and processing system programmed with the logic for electrical energy consumption measure data records in the timeline, an LCD screen to display messages from the microprocessor-based data collection and processing system, a communication channel to exchange data through the IP protocol, a set of buttons to change microprocessor input states and power supply circuits of one-phase AC, is that it has *n* separated tracks, preferably three tracks, which are connected to the supply line through the controllable current relays, controlled by a microprocessor-based data collection and processing system with a feedback channel being a channel for the transmission of measurement data and control messages in IP packets to/from external operator and connected to the electronic systems for measuring the consumption of electrical energy at each track individually, the microprocessor-based data collection and processing system has an LCD screen to display actual information of the system for measurement and control of electrical energy consumption status and has a set of buttons for interacting with user by displaying context menu on the LCD screen, and the supply of power to the tracks is controlled either manually using the buttons or automatically via the microprocessor system of data processing and collecting by switching on/off the controllable current relays.

The positive effect of the invention is that the system for measurement and control of electrical energy consumption allows for separation, from a uniform power line on the primary side, to *n* tracks at the secondary side, preferably three tracks, which are qualitatively different from each other and thus allows for practical implementation of the new method of electrical energy supply by power modes.

The invention in its embodiment is presented at a diagram figure, in schematic view of the key elements.

The system for measurement and control of electrical energy consumption has *n* separated tracks TR₁, TR₂, TR₃, ..., TRₙ, preferably three tracks, which are connected with powering line L1 through controllable current relays P₁, P₂, P₃, ... Pₙ, which are controlled by microprocessor-based data collection and processing system 3. The microprocessor-based data collection and processing system 3 has a feedback channel 4, which is the communication channel to exchange data with an external operator through the IP protocol. The microprocessor-based data collection and processing system 3 is connected to the electronic systems LE₁, LE₂, LE₃, ... LEₙ for measuring the consumption of electrical energy at each track TR₁, TR₂, TR₃, ..., TRₙ individually, the microprocessor system of control and data records has an LCD screen 6 to display actual information of the system for measurement and control of electrical energy consumption status and has a set of buttons 7 for interacting with user by displaying context menu on the LCD screen 6, and the supply of power to the tracks TR₁, TR₂, TR₃, ..., TRₙ is controlled either manually using the buttons PR₁, PR₂, PR₃, ... ,PRₙ or automatically via the microprocessor-based data collection and processing system 3 by switching on/off the controllable current relays P₁, P₂, P₃, ... ,Pₙ.

The operation of the system to measure and control consumption of electric energy is such that a single powering line L1 is split into n separated tracks TR₁, TR₂, TR₃, ... TRₙ, preferably three tracks, and with each track of secondary side there is assigned a quality parameter which informs about a power mode of electric energy the track is powered. Each of track TR₁, TR₂, TR₃, ... TRₙ of secondary side is individually measured by the electronic systems LE₁, LE₂, LE₃, ... LEₙ for measuring the consumption of electrical energy, and the measure data are recorded in persistent memory located inside the microprocessor-based data collection and processing system 3. The microprocessor-based data collection and processing system 3 records the measure data of electrical energy consumption of each of *n* tracks separately and stores this data both: cumulatively and with precision to the desired step of integration. The communication channel 4 to exchange data with an external operator through the IP protocol allows for two-way of communication, from the system unit to external operator and back communication. The electronic messages are exchanged in scalable structures of XML files. Such form of communication ensures uploading measurement data containing information of the electric energy consumption at each of track TR₁, TR₂, TR₃, ... TRₙ in direction to external operator, and, in the feedback direction, downloading data describing the values of quality parameters assigned to individual tracks TR₁, TR₂, TR₃, ... TRₙ, and other data significant in the energy management process for large numbers of customers equipped with the systems to measure and control consumption of electric energy. The system to measure and control consumption of electric energy initializes a communication transaction with remote operator in desired step of replication time, every time there are processed exchange the measure data of electric energy consumption for a period since the last successes transaction of communication and there are downloaded values of the quality parameters sets. The microprocessor-based data collection and processing system 3 parses the downloaded data and takes interpretation of quality parameters values and basis of that data the microprocessor-based data collection and processing system 3 takes control the availability of power supply into individual tracks TR₁, TR₂, TR₃, ... TRₙ of secondary side by switching on/off the controllable current relays P₁, P₂, P₃, ... ,Pₙ, which control the availability of power supply of correspondent tracks TR₁, TR₂, TR₃,
... TRₙ. The system to measure and control consumption of electric energy allows for manually control of power supply into individual tracks TR₁, TR₂, TR₃, ... TRₙ of secondary side independently of the communication channel 4 to exchange data is available or not. This is realized by buttons PR₁, PR₂, PR₃, ... ,PRₙ for manual control, which manage the state of controllable current relays P₁, P₂, P₃, ... ,Pₙ. The buttons PR₁, PR₂, PR₃, ... ,PRₙ switch on/off a correspondent controllable current relays P₁, P₂, P₃, ... ,Pₙ and in this way control the availability of power supply of correspondent tracks TR₁, TR₂, TR₃,
... TRₙ of secondary side. The system to measure and control consumption of electric energy has an LCD screen 6 to display actual information about electrical energy consumption of each tracks TR₁, TR₂, TR₃, ... TRₙ of secondary side and some important information of the system to measure and control consumption of electric energy status are there displayed too. Moreover the system to measure and control consumption of electric energy has a set of buttons 7 for interacting with an user of the system by displaying the context menu on the LCD screen 6.

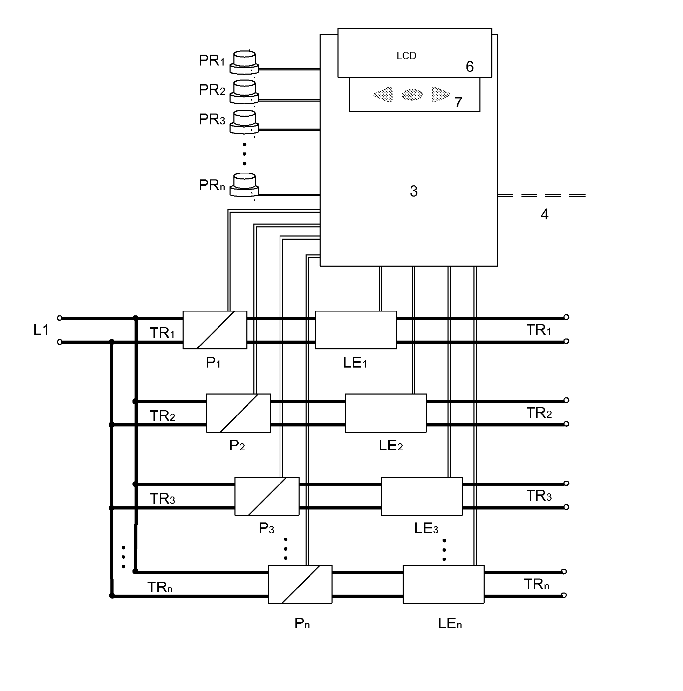

## Claims

**1.** The system for measurement and control of electrical energy consumption, which is composed of controllable current relays, electronic systems for measuring the consumption of electric energy, the microprocessor system programmed with the logic for electrical energy consumption measure data records in the timeline, an LCD display to display messages from the microprocessor system, a communication channel to exchange data through the IP protocol, a set of buttons to change microprocessor input states and power supply circuits of one-phase AC, **characterized in that** it has *n* separated tracks (TR₁, TR₂, TR₃, ..., TRₙ), preferably three tracks, which are connected to the supply line (L1) through the controllable current relays (P₁, P₂, P₃, ... Pₙ), controlled by a microprocessor-based data collection and processing system (3), with the feedback channel (4) being a channel for the transmission of measurement data and control messages in IP packets to/from external operator and connected to the electronic systems (LE₁, LE₂, LE₃, ... LEₙ) for measuring the consumption of electrical energy at each track (TR₁, TR₂, TR₃, ..., TRₙ) individually, the microprocessor-based data collection and processing system (3) has an LCD screen (6) to display actual information of the system for measurement and control of electrical energy consumption status and has a set of buttons (7) for interacting with user by displaying context menu on the LCD screen (6), and the supply of power to the tracks (TR₁, TR₂, TR₃, ..., TRₙ) is controlled either manually using the buttons (PR₁, PR₂, PR₃, ... ,PRₙ) or automatically via the microprocessor-based data collection and processing system (3) by switching on/off the controllable current relays (P₁, P₂, P₃, ....Pₙ).
